# EUROPEAN PATENT APPLICATION

(11) **EP 4 708 365 A1**
(43) Date of publication of application: **11.03.2026**
(21) Application number: 24818335.2
(22) Date of filing: 21.03.2024
(51) Int. Cl.: H01L 31/0224, H01L 31/042

(54) **BACK-CONTACT SOLAR CELL, CELL ASSEMBLY, AND PHOTOVOLTAIC SYSTEM**

(30) Priority: 09.06.2023 CN 202321482150 U; 09.06.2023 CN 202310688909
(71) Applicant: Guangdong Aiko Solar Energy Technology Co., Ltd., Foshan, Guangdong 528000 (CN); Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Zhejiang Aiko Solar Energy Technology Co., Ltd., Yiwu, Jinhua Zhejiang 322000 (CN)
(72) Inventor: WANG, Yongqian, Foshan, Guangdong 528000 (CN); CHEN, Gang, Foshan, Guangdong 528000 (CN)
(74) Representative: EP&C
(86) International application number: PCT/CN2024/083064
(87) International publication number: WO 2024/250798

(57) **Abstract**

A back-contact solar cell (100), a cell assembly (200) and a photovoltaic system (1000). **In a** back electrode structure (20) of the back-contact solar cell (100), first fingers (21) include first finger pre-plating layers (211) forming ohmic contact with a substrate (10) and first finger electroplating layers (212) plating the first finger pre-plating layers (211), and second fingers (22) include second finger pre-plating layers (221) forming ohmic contact with the substrate (10) and second finger electroplating layers (222) plating the second finger pre-plating layers (221). The first busbars (23) make contact with the first finger pre-plating layers (211), the first fingers (21) are disconnected at second busbars (24), the second busbars (24) make contact with the second finger pre-plating layers (221), and the second fingers (22) are disconnected at the first busbars (23). A first conductive connector (30) and a second conductive connector (40) are arranged at two ends of the first busbars (23) and the second busbars (24) respectively, the first conductive connector (30) is connected to ends of all the first busbars (23) facing away from the second conductive connector (40), and the second conductive connector (40) is connected to ends of all the second busbars (24) facing away from the first conductive connector (30).

## Description

### Cross-Reference to Related Application

The present disclosure claims the priority and benefit of Patent Application No. 202321482150.1 and Patent Application No. 202310688909.X filed with the China National Intellectual Property Administration on June 9, 2023, which is incorporated in their entireties herein by reference.

### Technical Field

The present disclosure relates to the technical field of solar cells, and in particular to a back-contact solar cell, a cell assembly, and a photovoltaic system.

### Background

A back-contact solar cell is a type of solar cell with P regions and N regions on the back of the cell. Because the front of the cell is not blocked by any metal electrode, a short circuit current of the cell can be effectively increased, and the cell efficiency can be improved. The P regions and the N regions on the back are arranged alternately. Fingers are arranged on the P regions and the N regions. The fingers are connected to busbars with corresponding polarities. To avoid short circuits, the fingers are usually connected to busbars with the same polarity and disconnected at busbars with different polarities. For example, a positive finger is disconnected at a negative busbar, and a negative finger is disconnected at a positive busbar. That is, the fingers are designed to be discontinuous and divided into a plurality of finger segments.

In the related art, electroplating design can be employed in the fingers of the back-contact solar cell. For example, a discontinuous finger metal layer can be pre-arranged in a region where fingers need to be arranged, then an electroplating layer can be formed on the finger metal layer by an electroplating device through electroplating (for example, copper electroplating), and finally the fingers are formed.

### Summary

The present disclosure provides a back-contact solar cell, a cell assembly, and a photovoltaic system.

The back-contact solar cell in an example of the present disclosure includes a substrate and at least one back electrode structure arranged on a light-sheltered surface of the substrate. Each back electrode structure includes:
several first fingers and several second fingers that are spaced in a first direction and alternately arranged in sequence, where the first fingers include first finger pre-plating layers forming ohmic contact with the substrate and first finger electroplating layers plating the first finger pre-plating layers, and the second fingers include second finger pre-plating layers forming ohmic contact with the substrate and second finger electroplating layers plating the second finger pre-plating layers;
several first busbars and several second busbars that are spaced in a second direction and alternately arranged in sequence, where the first direction intersects with the second direction, the first busbars make contact with the first finger pre-plating layers, the first fingers are disconnected at the second busbars, the second busbars make contact with the second finger pre-plating layers, and the second fingers are disconnected at the first busbars; and
a first conductive connector and a second conductive connector, where the first conductive connector and the second conductive connector are arranged at two ends of the first busbars and the second busbars respectively, the first conductive connector is connected to ends of all the first busbars facing away from the second conductive connector, and the second conductive connector is connected to ends of all the second busbars facing away from the first conductive connector.

The present disclosure further provides a battery assembly. The battery assembly includes the plurality of any one of the back-contact solar cells above, or a plurality of sliced cells obtained by cutting and/or fragmenting the any one of the back-contact solar cells.

The present disclosure further provides a photovoltaic system. The photovoltaic system includes the cell assembly described above.

Some additional aspects and advantages of the present disclosure will be set forth in the following description, and other additional aspects and advantages will be apparent from the following description or learned by practice of the present disclosure.

### Brief Description of the Drawings

Fig. 1 is a schematic diagram of assemblys of a photovoltaic system according to an example of the present disclosure;
Fig. 2 is a schematic diagram of assemblys of a cell assembly according to an embodiment of the present disclosure;
Fig. 3 is a schematic diagram of a planar structure of a back-contact solar cell according to an example of the present disclosure;
Fig. 4 is a schematic diagram of a section structure of the back-contact solar cell in line IV-IV in Fig. 3;
Fig. 5 is a schematic diagram of another planar structure of a back-contact solar cell according to an example of the present disclosure;
Fig. 6 is a schematic diagram of yet another planar structure of a back-contact solar cell according to an example of the present disclosure;
Fig. 7 is a schematic diagram of yet another planar structure of a back-contact solar cell according to an example of the present disclosure;
Fig. 8 is a schematic diagram of yet another planar structure of a back-contact solar cell according to an example of the present disclosure;
Fig. 9 is a schematic diagram of still another planar structure of a back-contact solar cell according to an example of the present disclosure;
Fig. 10 is a schematic diagram of a section structure of the back-contact solar cell in line X-X in Fig. 3; and
Fig. 11 is a schematic diagram of a section structure of the back-contact solar cell in line XI-XI in Fig. 3.

Reference numerals:
photovoltaic system 1000, cell assembly 200, back-contact solar cell 100, substrate 10, silicon wafer 11, first polar doped layer 12, second polar doped layer 13, electrode arrangement region 14, back electrode structure 20, first finger 21, first finger pre-plating layer 211, first finger electroplating layer 212, second finger 22, second finger pre-plating layer 221, second finger electroplating layer 222, first busbar 23, first busbar pre-plating layer 231, first busbar electroplating layer 232, second busbar 24, second busbar pre-plating layer 241, second busbar electroplating layer 242, first conductive connector 30, second conductive connector 40, and a passivation film layer 50.

### Detailed Description of the Embodiments

In order to make the objectives, technical solutions, and advantages of the present disclosure clearer, the disclosure will be further described in detail below with reference to the accompanying drawings and examples. The examples are illustratively shown in the accompanying drawings. The same or similar reference numerals denote the same or similar elements or elements having the same or similar functions throughout. The examples described below with reference to the accompanying drawings are illustrative and are intended to explain the present disclosure, but cannot be interpreted as limiting the present disclosure. Furthermore, it should be understood that the specific examples described herein are merely used to explain the present disclosure and are not intended to limit the present disclosure.

**In** the description of the present disclosure, it should be understood that the orientation or position relations indicated by the terms "up," "down," "transverse," "longitudinal," etc. are based on the orientation or position relations shown in the accompanying drawings, are merely for facilitating the description of the present disclosure and simplifying the description, rather than indicating or implying that the device or element referred to must have a particular orientation or be constructed and operated in a particular orientation, and therefore cannot be interpreted as limiting the present disclosure.

Moreover, the terms "first" and "second" are merely for description and cannot be interpreted as indicating or implying relative importance or implicitly indicating the number of technical features indicated. Thus a feature limited by "first" or "second" may explicitly or implicitly include one or more of the features. **In** the description of the present disclosure, unless otherwise definitely and specifically defined, "a plurality" means two or more.

The following disclosure provides various different examples or instances configured to implement different structures of the present disclosure. Components and configurations in specific instances are described below, in order to simplify the contents of the present disclosure. Clearly, the components and configurations are merely illustrative and are not intended to limit the present disclosure. Furthermore, the present disclosure can repeat the reference numerals and/or reference letters in different instances. Such repetition is for simplicity and clarity and does not indicate a relation between various discussed examples and/or configurations. Moreover, the present disclosure provides instances of various specific processes and materials, but those of ordinary skill in the art can recognize applications of other processes and/or use scenarios of other materials.

**In** the present disclosure, through arrangement of the first conductive connectors and the second conductive connectors, the first conductive connectors may be connected to the ends of all the first busbars to be in communication with the first finger pre-plating layers making contact with the first busbars, and the second conductive connectors may be connected to the ends of all the second busbars to be in communication with the second finger pre-plating layers making contact with the second busbars. Thus when the first finger electroplating layers and the second finger electroplating layers are formed, the first finger electroplating layers and the second finger electroplating layers can be formed on all the first finger pre-plating layers and the second finger pre-plating layers respectively only by connecting a cathode of an electroplating apparatus to the first conductive connectors and the second conductive connectors separately. An electroplating process can be completed without sequentially connecting the cathode of the electroplating apparatus to the first busbars and the second busbars or sequentially connecting the cathode of the electroplating apparatus to the disconnected first finger pre-plating layers and the second finger pre-plating layers. The electroplating process is simplified effectively, and electroplating efficiency is improved.

### Example 1

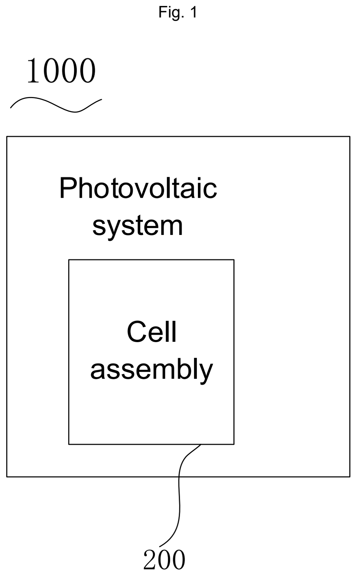

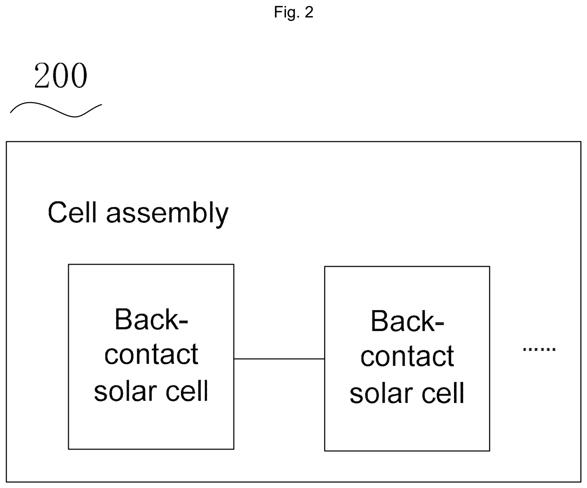

With reference to Fig. 1 to Fig. 2, a photovoltaic system 1000 in the example of the present disclosure may include a cell assembly 200 in the example of the present disclosure. The cell assembly 200 in the example of the present disclosure may include a plurality of back-contact solar cells 100 in the example of the present disclosure or a plurality of sliced cells obtained by cutting and/or fragmenting the back-contact solar cells 100 in the example of the present disclosure. It should be noted that the sliced cells may be two segments, three segments, four segments, etc., and are not limited herein.

In the cell assembly 200, the plurality of back-contact solar cells 100 or the plurality of sliced cells may be sequentially connected in series to form a plurality of cell strings. All the cell strings may be connected in series, in parallel, or in series-parallel to realize a bus output of currents. For example, all the cells may be connected by welding a solder ribbon, and all the cell strings may be connected through bus bars.

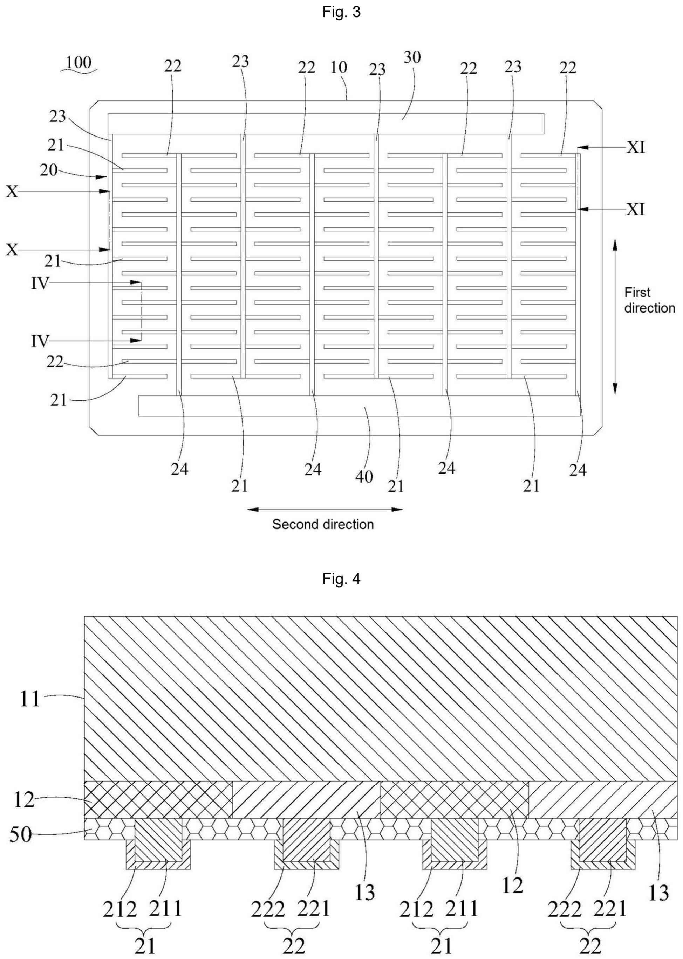

With reference to Fig. 3 and Fig. 4, the back-contact solar cell 100 in the example of the present disclosure may include a substrate 10 and a back electrode structure 20 arranged on a light-sheltered surface of the substrate 10.

The substrate 10 may include a silicon wafer 11, and first polar doped layers 12 and second polar doped layers 13 alternately arranged on a back surface of the silicon wafer 11 in sequence. The silicon wafer 11 may be a P-type silicon wafer or an N-type silicon wafer, which is not limited herein. A light-sheltered surface of the substrate 10 is the back surface of the back-contact solar cell 100. A polarity of the first polar doped layers 12 and a polarity of the second polar doped layer 13 are opposite. For example, the first polar doped layers 12 may be P-type doped layers, and the second polar doped layers 13 may be N-type doped layers. For another example, the first polar doped layers 12 may be N-type doped layers, and the second polar doped layers 13 may be P-type doped layers, which are not limited herein.

With reference to Fig. 3, the back electrode structure 20 may include several first fingers 21, several second fingers 22, several first busbars 23, several second busbars 24, a first conductive connector 30, and a second conductive connector 40.

The several first fingers 21 and the several second fingers 22 may be spaced in a first direction and alternately arranged. The several first busbars 23 and the several second busbars 24 may be spaced in a second direction and alternately arranged. The first direction intersects with the second direction. The first fingers 21 may be correspondingly arranged on the first polar doped layers 12. The second fingers 22 may be correspondingly arranged on the second polar doped layers 13.

**In** the example of the present disclosure, the first direction and the second direction may be perpendicular to each other. For example, as shown in Fig. 3, the first direction may be a longitudinal direction of the back-contact solar cell 100. The second direction may be a transverse direction of the back-contact solar cell 100. The first fingers 21 and the second fingers 22 may be alternately arranged in the longitudinal direction and extend in the transverse direction. The first busbars 23 and the second busbars 24 may be alternately arranged in the transverse direction and extend in the longitudinal direction.

With reference to Fig. 4, the first fingers 21 may include first finger pre-plating layers 211 forming ohmic contact with the substrate 10 and first finger electroplating layers 212 plating the first finger pre-plating layers 211. The second fingers 22 may include second finger pre-plating layers 221 forming ohmic contact with the substrate 10 and second finger electroplating layers 222 plating the second finger pre-plating layers 221. The first busbars 23 make contact with the first finger pre-plating layers 211. The first fingers 21 are disconnected at second busbars 24. The second busbars 24 make contact with the second finger pre-plating layers 221. The second fingers 22 are disconnected at the first busbars 23.

Specifically, the first finger pre-plating layers 211 may form ohmic contact with the first polar doped layers 12. The second finger pre-plating layers 221 may form ohmic contact with the second polar doped layers 13. Electrodes 11 of the first fingers 21 are used for collecting a current in a region of the silicon wafer 11 corresponding to the first polar doped layers 12. The second fingers 2212 are used for collecting a current in a region of the silicon wafer 11 corresponding to the second polar doped layers 13. As shown in Fig. X, the first fingers 21 are disconnected at the second busbars 24 to form a plurality of finger segments, that is, the second fingers 22 are disconnected at the first busbars 23 to form a plurality of finger segments.

It should be noted that in the present disclosure, the first polar doped layers 12 and the second polar doped layers 13 on the silicon wafer 11 may be formed by deposition, laser doping, metal doping, etc., which is not limited herein. Furthermore, in the present disclosure, the first polar doped layers 12 and the second polar doped layers 13 may be in direct or indirect contact, preferably in indirect contact. In this case, the first polar doped layers and the second polar doped layers may be isolated by physical isolation. For example, the first polar doped layers 12 and the second polar doped layers 13 may be directly spaced. For another example, a trench may be formed in the silicon wafer 11 to isolate the first polar doped layers and the second polar doped layers. For another example, a trench may be formed in the silicon wafer 11, and one of the first polar doped layers 12 and the second polar doped layers 13 may be arranged in the trench to achieve isolation.

Clearly, it should be understood that in some examples, the first polar doped layers 12 and the second polar doped layers 13 may make contact with each other locally, or a small number of the first polar doped layers 12 and the second polar doped layers 13 in the plurality of first polar doped layers 12 and the plurality of second polar doped layers 13 may make contact with each other, which is not limited herein.

With reference to Fig. 3, the first conductive connector 30 and the second conductive connector 40 may be arranged at two ends of the first busbars 23 and the second busbars 24 respectively. As shown in Fig. 3, the first conductive connector 30 and the second conductive connector 40 may be arranged on an upper side and a lower side of both the first busbars 23 and the second busbars 24 respectively. The first conductive connector 30 is connected to ends of all the first busbars 23 facing away from the second conductive connector 40. The second conductive connector 40 is connected to ends of all the second busbars 24 facing away from the first conductive connector 30.

In the related art, the back-contact solar cell is a type of solar cell with P regions and N regions on the back of the cell. Because the front of the cell is not blocked by any metal electrode, a short circuit current of the cell can be effectively increased, and the cell efficiency can be improved. The P regions and the N regions on the back are arranged alternately. Fingers are arranged on the P regions and the N regions. The fingers are connected to busbars with corresponding polarities. To avoid short circuits, the fingers are usually connected to busbars with the same polarity and disconnected at busbars with different polarities. For example, a positive finger is disconnected at a negative busbar, and a negative finger is disconnected at a positive busbar. That is, the fingers are designed to be discontinuous and divided into a plurality of finger segments. However, in this case, since the fingers are designed to be discontinuous, each finger is divided into a plurality of independent finger segments. In order to make all the finger segments have an electroplating layer in an electroplating process, a cathode of the electroplating apparatus needs to be connected to the independent finger segments in sequence or connected to the busbars making contact with the finger segments in sequence, such that all the finger segments can be plated with the electroplating layer. The electroplating process is complicated, and electroplating efficiency is low.

**In** the back-contact solar cell 100, the cell assembly 200 and the photovoltaic system 1000 in the example of the present disclosure, the first busbars 23 make contact with the first finger pre-plating layers 211. The second busbars 24 make contact with the second finger pre-plating layers 221. The first conductive connector 30 and the second conductive connector 40 are arranged at two ends of the first busbars 23 and the second busbars 24 respectively. The first conductive connector 30 is connected to ends of all the first busbars 23 facing away from the second conductive connector 40. The second conductive connector 40 is connected to ends of all the second busbars 24 facing away from the first conductive connector 30. In this way, through arrangement of the first conductive connector 30 and the second conductive connector 40, the first conductive connector 30 may be connected to the ends of all the first busbars 23 to be in communication with the first finger pre-plating layers 211 making contact with the first busbars 23. The second conductive connector 40 may be connected to the ends of all the second busbars 24 to be in communication with the second finger pre-plating layers 221 making contact with the second busbars 24. Thus when the first finger electroplating layers 212 and the second finger electroplating layers 222 are formed, the first finger electroplating layers 212 and the second finger electroplating layers 222 can be formed on all the first finger pre-plating layers 211 and the second finger pre-plating layers 221 respectively only by connecting a cathode of the electroplating apparatus to the first conductive connector 30 and the second conductive connector 40 separately. The electroplating process can be completed without sequentially connecting the cathode of the electroplating apparatus to the first busbars 23 and the second busbars 24 or sequentially connecting the cathode of the electroplating apparatus to the disconnected first finger pre-plating layers 211 and the second finger pre-plating layers 221. The electroplating process is simplified effectively, and electroplating efficiency is improved.

In the example of the present disclosure, the first finger electroplating layers 212 and the second finger electroplating layers 222 may be electroplated copper layers. The first conductive connector 30 and the second conductive connector 40 may be metal connectors having conductive functions, and may have regular or irregular shapes. For example, in some examples, the first conductive connector and the second conductive connector may be linear, may be parallel to the first fingers 21 and the second fingers 22, or may be arranged obliquely relative to the first fingers 21 and the second fingers 22. For example, in some examples, the first conductive connector and the second conductive connector may have other shapes, such as a wavy shape and an arc shape, which is not limited herein.

Furthermore, with reference to Fig. 4, in some examples, a passivation film layer 50 may be further arranged on the light-sheltered surface of the substrate 10. The passivation film layer 50 covers the entire light-sheltered surface. The first finger pre-plating layers 211 penetrate the passivation film layer 50 and then form ohmic contact with the first polar doped layers 12. The second finger pre-plating layers 221 penetrate the passivation film layer 50 and then form ohmic contact with the second polar doped layers 13. Moreover, in some examples, a tunneling layer (not shown) may be arranged between the back surface of the silicon wafer 11 and the first polar doped layers 12 as well as the second polar doped layers 13.

It can be understood that in the example of the present disclosure, the cell assembly 200 may further include a metal frame, a back plate, photovoltaic glass, and an adhesive film (none of the above are shown in the figures). The adhesive film may fill gaps between a front surface of the back-contact solar cell 100 and the photovoltaic glass, between a rear surface of the back-contact solar cell and the back plate, between adjacent cells, etc. The adhesive film, filler, may be a transparent adhesive having desirable light transmission performance and aging resistance. For example, the adhesive film may be a polyethylene vinylacetate (EVA) adhesive film or a polyethylene-1-octene (POE) adhesive film, which may be specifically selected according to an actual situation and is not limited herein.

The photovoltaic glass may cover the adhesive film on the front surface of the back-contact solar cell 100. The photovoltaic glass may be ultra-clear glass having high transmittance, high transparency, and excellent physical, mechanical, and optical properties. For example, the ultra-clear glass may have the transmittance of 92% or higher and protect the back-contact solar cell 100 without affecting the efficiency of the back-contact solar cell 100 as much as possible. Moreover, the photovoltaic glass may adhere to the back-contact solar cell 100 through the adhesive film. The adhesive film may seal, insulate, and waterproof the back-contact solar cell 100.

The back plate may adhere to the adhesive film on the rear surface of the back-contact solar cell 100 to protect and support the back-contact solar cell 100, and has the reliable insulativity, water resistance, and aging resistance. A plurality of materials may be selected as the back plate, generally including tempered glass, organic glass, an aluminum alloy and Tedlar, polyethylene terephthalate and Tedlar (TPT) composite adhesive film, etc., which may be specifically configured according to a specific condition and is not limited herein. An assembly formed by the back plate, the back-contact solar cell 100, the adhesive film, and the photovoltaic glass may be arranged on the metal frame. The metal frame serves as a primary external support structure of an entire cell assembly 200, so as to stably support and mount the cell assembly 200. For example, the cell assembly 200 may be mounted at a desired position through the metal frame.

Further, in the example, the photovoltaic system 1000 may be applied to photovoltaic power stations, such as a ground power station, a rooftop power station, and a water surface power station, and may also be applied to apparatuses or devices that generate power through solar energy, such as a solar power source of a user, a solar street lamp, a solar vehicle, and a solar building. Clearly, it can be understood that the application scenarios of the photovoltaic system 1000 are not limited to the above. **In** other words, the photovoltaic system 1000 may be applied to all fields for power generation through solar energy. With a photovoltaic power generation system network as an example, the photovoltaic system 1000 may include a photovoltaic array, a bus box, and an inverter. The photovoltaic array may be an array combination of a plurality of cell assemblies 200. For example, the plurality of cell assemblies 200 may form a plurality of photovoltaic arrays, and the photovoltaic arrays are connected to the bus box. The bus box may combine currents generated through the photovoltaic arrays. The currents combined flow through the inverter to be converted into alternating currents required by a mains power grid and then are connected to the mains power grid to realize power supply through solar energy.

In some examples, each of the first finger pre-plating layers 211 and the second finger pre-plating layers 221 may include a seed layer. The seed layer may be prepared through a physical vapor deposition method. In this way, stable ohmic contact can be formed with the first polar doped layers 12 and the second polar doped layers 13 through the seed layers.

Specifically, the seed layers may be made of metallic material, which may preferably be alloy material. In some examples, a major component of the seed layers may include copper, aluminum or nickel.

In some examples, the seed layers may include a main component and a strengthening component. The main component may include any one or more of aluminum, silver, copper, magnesium, etc., and the strengthening component may include any one or more of molybdenum, titanium, tungsten, nickel, etc. Clearly, in some possible examples, the seed layers may be a single metal layer, as long as it can implement a subsequent plating function, which is not limited herein.

In such an example, the passivation film layer 50 may be deposited on the substrate 10 first. Then the passivation film layer 50 is opened in regions corresponding to the first finger pre-plating layers 211 and the second finger pre-plating layers 221. Then, the seed layers are deposited at openings through a physical vapor deposition method, to form the first finger pre-plating layers 211 and the second finger pre-plating layers 221 that form ohmic contact with the first polar doped layers 12 and the second polar doped layers 13 respectively.

Furthermore, in some embodiments, the first finger pre-plating layers 211 and the second finger pre-plating layers 221 may also be prepared through a light-induced electroplating method or a chemical electroplating method, which is not limited herein. **In** this case, components of the first finger pre-plating layers 211 and the second finger pre-plating layers 221 may include copper or nickel.

### Example 2

With reference to Fig. 3, in some examples, a width of the first conductive connector 30 is greater than a width of each first finger pre-plating layer 211. A width of the second conductive connector 40 is greater than a width of each second finger pre-plating layer 221.

In this way, setting the widths of the first conductive connector 30 and the second conductive connector 40 to be greater can facilitate connection of the first conductive connector 30 and the second conductive connector 40 to the cathode of the electroplating apparatus, so as to guarantee reliability of electroplating.

Meanwhile, since the first conductive connector 30 connects all the first busbars 23 together, and the second conductive connector 40 connects all the second busbars 24 together, compared with the first finger pre-plating layers 211 and the second finger pre-plating layers 221, the first conductive connector 30 and the second conductive connector 40 need to have a better overcurrent capability to guarantee that the first conductive connector 30 and the second conductive connector 40 do not have an overcurrent and cause fusing. Thus reliability of the back-contact solar cell 100 can be guaranteed by setting the widths of the first conductive connector 30 and the second conductive connector 40 to be greater.

It should be noted that "width" herein refers to a size of each component in the first direction (that is, the longitudinal direction), and can be used as reference for understanding the same description hereinafter.

### Example 3

In some examples, a width of each first finger pre-plating layer 211 may be 0.03 mm to 1 mm. A width of each first conductive connector 30 may be 0.1 mm to 10 mm.

In this way, setting the width of each first finger pre-plating layer 211 in a reasonable range of 0.03 mm to 1 mm may guarantee an electroplating effect while forming reliable ohmic contact with the substrate 10. Setting the width of each first conductive connector 30 in a reasonable range of 0.1 mm to 10 mm may guarantee an overcurrent capability of each first conductive connector 30 while guaranteeing reliability of connection to the cathode of the electroplating apparatus. Thus, reliability of the back-contact solar cell 100 is guaranteed.

Specifically, in such an example, the width of each first finger pre-plating layer 211 may be, for example, 0.03 mm, 0.04 mm, 0.05 mm, 0.06 mm, 0.07 mm, 0.08 mm, 0.09 mm, 0.1 mm, 0.2 mm, 0.3 mm, 0.4 mm, 0.5 mm, 0.6 mm, 0.7 mm, 0.8 mm, 0.9 mm, 1 mm, or any value between 0.03 mm and 1 mm, which is not limited herein.

The width of each first conductive connector 30 may be, for example, 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, 6 mm, 7 mm, 8 mm, 9 mm, 10 mm, or any value between 0.1 mm and 10 mm, which is not limited herein.

Further, in such an example, the width of each first finger pre-plating layer 211 may preferably be 0.03 mm to 0.6 mm, and the width of each first conductive connector 30 may preferably be 0.1 mm to 5 mm.

Specifically, the inventors of the present disclosure have found through verification and research that in a case that the width of each first finger pre-plating layer 211 is less than 0.03 mm, unstable ohmic contact formed with the substrate 10 is easily caused, and a subsequent electroplating effect is influenced. However, in a case that the width of each first finger pre-plating layer 211 is greater than 0.6 mm, cost is greatly increased. Accordingly, setting the width of each first finger pre-plating layer 211 in a preferable range of 0.03 mm to 0.6 mm can effectively reduce the cost while guaranteeing contact reliability and the electroplating effect.

Furthermore, the inventors of the present disclosure have also found through verification and research that in a case that the width of each first conductive connector 30 is less than 0.1 mm, poor contact with an electrode in an electroplating process is easily caused, and after subsequent electroplating, an overcurrent is likely to occur at each first conductive connector 30 and cause fusing. Thus the reliability of the back-contact solar cell 100 is reduced. However, in a case that the width of each first conductive connector 30 is greater than 5 mm, a significant increase in cost is caused. Accordingly, setting the width of each first conductive connector 30 in a preferable range of 0.1 mm to 5 mm can effectively control the cost while guaranteeing electroplating reliability and the reliability of the back-contact solar cell 100.

### Example 4

In some examples, a width of each second finger pre-plating layer 221 may be 0.03 mm to 1 mm. A width of each second conductive connector 40 may be 0.1 mm to 10 mm.

In this way, setting the width of each second finger pre-plating layer 221 in a reasonable range of 0.03 mm to 1 mm may guarantee an electroplating effect while forming reliable ohmic contact with the substrate 10. Setting the width of each second conductive connector 40 in a reasonable range of 0.1 mm to 10 mm may guarantee an overcurrent capability of each second conductive connector 40 while guaranteeing reliability of connection to the cathode of the electroplating apparatus. Thus, reliability of the back-contact solar cell 100 is guaranteed.

Specifically, in such an example, the width of each second finger pre-plating layer 221 may be, for example, 0.03 mm, 0.04 mm, 0.05 mm, 0.06 mm, 0.07 mm, 0.08 mm, 0.09 mm, 0.1 mm, 0.2 mm, 0.3 mm, 0.4 mm, 0.5 mm, 0.6 mm, 0.7 mm, 0.8 mm, 0.9 mm, 1 mm, or any value between 0.03 mm and 1 mm, which is not limited herein.

The width of each second conductive connector 40 may be, for example, 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, 6 mm, 7 mm, 8 mm, 9 mm, 10 mm, or any value between 0.1 mm and 10 mm, which is not limited herein.

Further, in such an example, the width of each second finger pre-plating layer 221 may preferably be 0.03 mm to 0.6 mm, and the width of each second conductive connector 40 may preferably be 0.1 mm to 5 mm.

Specifically, the inventors of the present disclosure have found through verification and research that in a case that the width of each second finger pre-plating layer 221 is less than 0.03 mm, unstable ohmic contact formed with the substrate 10 is easily caused, and a subsequent electroplating effect is influenced. However, in a case that the width of each second finger pre-plating layer 221 is greater than 0.6 mm, cost is greatly increased. Accordingly, setting the width of each second finger pre-plating layer 221 in a preferable range of 0.03 mm to 0.6 mm can effectively reduce the cost while guaranteeing contact reliability and the electroplating effect.

Furthermore, the inventors of the present disclosure have also found through verification and research that in a case that the width of each second conductive connector 40 is less than 0.1 mm, poor contact with an electrode in an electroplating process is easily caused, and after subsequent electroplating, an overcurrent is likely to occur at each second conductive connector 40 and cause fusing. Thus the reliability of the back-contact solar cell 100 is reduced. However, in a case that the width of each second conductive connector 40 is greater than 5 mm, a significant increase in cost is caused. Accordingly, setting the width of each second conductive connector 40 in a preferable range of 0.1 mm to 5 mm can effectively control the cost while guaranteeing electroplating reliability and the reliability of the back-contact solar cell 100.

### Example 5

With reference to Fig. 3, in some examples, the first conductive connector 30 and the second conductive connector 40 are parallel to the first finger pre-plating layers 211 and the second finger pre-plating layers 221. According to this arrangement, a situation that a size of the back-contact solar cell 100 is increased due to a larger space occupied by the inclined first conductive connector 30 and the inclined second conductive connector 40 can be avoided.

### Example 6

In some examples, each first conductive connector 30 may form ohmic contact with the substrate 10. Specifically, the first polar doped layers 12 may be arranged in a region corresponding to each first conductive connector 30. Each first conductive connector 30 may penetrate the passivation film layer 50 and then form ohmic contact with the corresponding first polar doped layers 12.

In this way, each first conductive connector 30 may implement a function of collecting carriers in the silicon wafer 11 while being connected to the first busbars 23, and efficiency can be effectively improved.

Similarly, in some examples, each second conductive connector 40 may also form ohmic contact with the substrate 10. Specifically, the second polar doped layers 13 may be arranged in a region corresponding to each second conductive connector 40. Each second conductive connector 40 may penetrate the passivation film layer 50 and then form ohmic contact with the corresponding second polar doped layers 13.

In this way, each second conductive connector 40 may implement a function of collecting carriers in the silicon wafer 11 while being connected to the second busbars 24, and efficiency can be effectively improved.

Clearly, it can be understood that in other examples, each first conductive connector 30 may make no contact with the substrate 10, but may be connected to the first busbars 23 and suspended on the substrate 10. Similarly, in some examples, each second conductive connector 40 may make no contact with the silicon wafer 11, but may be connected to the second busbars 24 and suspended on the substrate 10. In this case, each first conductive connector 30 and each second conductive connector 40 may be directly suspended or arranged on the passivation film layer 50 without penetrating the passivation film layer 50.

### Example 7

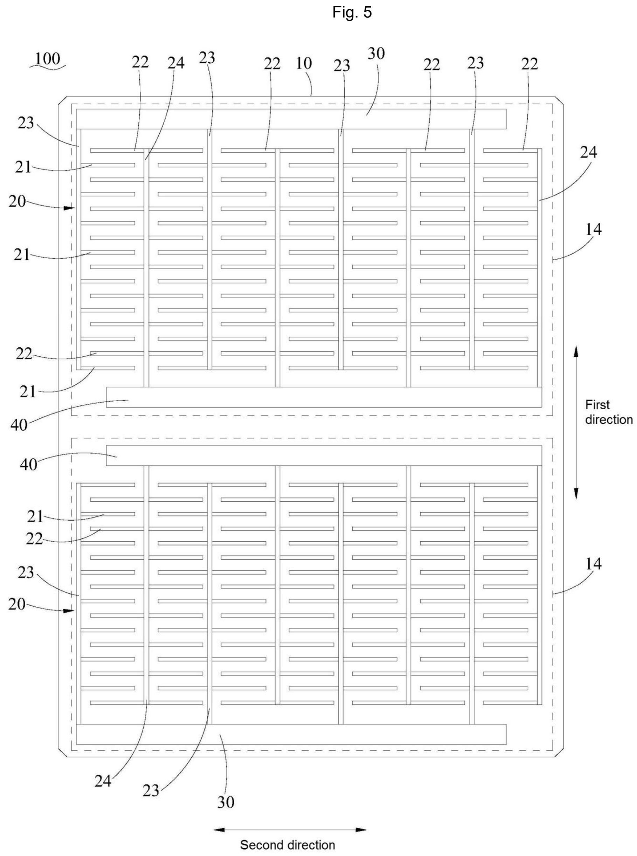

With reference to Fig. 5 to Fig. 9, a light-sheltered surface of the substrate 10 may have several electrode arrangement regions 14 in the first direction. The back electrode structure 20 is arranged in each electrode arrangement region 14.

In this way, the light-sheltered surface of the substrate 10 is divided into several electrode arrangement regions 14. A back electrode structure 20 is arranged in each region. Subsequently, the back-contact solar cell 100 can be cut and/or split to divide the back-contact solar cell 100 into a plurality of sliced cells, that is, the first finger pre-plating layers 211 and the second finger pre-plating layers 221 in all the electrode arrangement regions 14 can be electroplated by an electroplating process, and then divided to obtain the sliced cells.

Specifically, as shown in Fig. 5 to Fig. 8, in the examples shown in Fig. 5 to Fig. 8, the back-contact solar cell 100 may have two electrode arrangement regions 14. **In** this case, two-segment sliced cells may be obtained after segmentation.

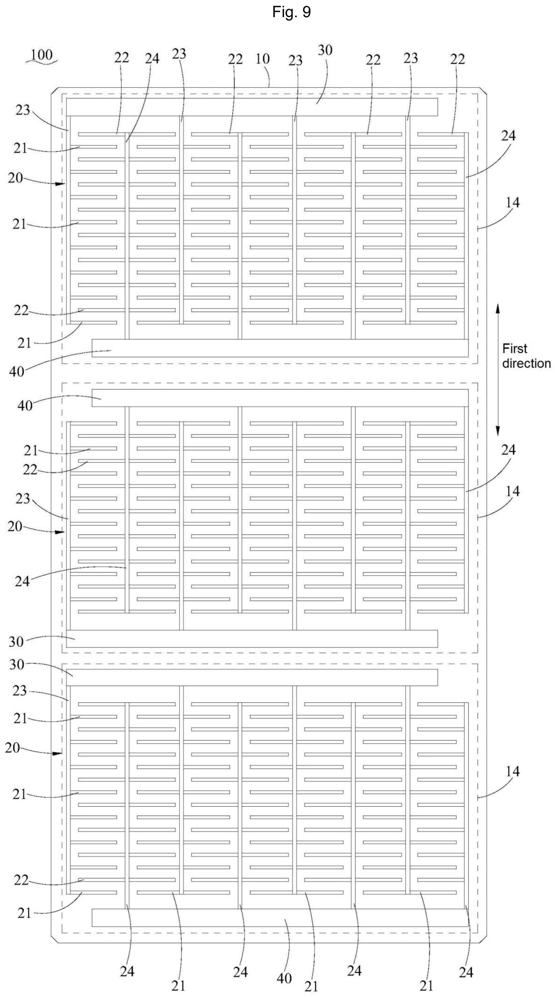

In an example shown in Fig. 9, the back-contact solar cell 100 may have three electrode arrangement regions 14. In this case, three-segment sliced cells may be obtained after segmentation. Clearly, the back-contact solar cell 100 may also have three or more electrode arrangement regions 14. In this way, more sliced cells can be obtained after cutting. That is, when a number of the electrode arrangement regions 14 is N (N is a positive integer greater than 1), N-segment sliced cells can be obtained after segmentation.

### Example 8

With reference to Fig. 5, in some examples, in the two adjacent back electrode structures 20, the second conductive connectors 40 in the two back electrode structures 20 are adjacent to each other.

In this way, the second conductive connectors 40 of the two adjacent back electrode structures 20 are adjacent to each other. When the cell needs to be segmented into sliced cells, the cell can be divided according to an interval between the two second conductive connectors 40 to obtain the sliced cells. After segmentation is completed, the sliced cells can be connected by solder tapes to form a cell string. When the cell does not need to be segmented into sliced cells, the two adjacent second conductive connectors 30 are directly connected by solder tapes or bus bars, such that adjacent back electrode structures 20 are in communication.

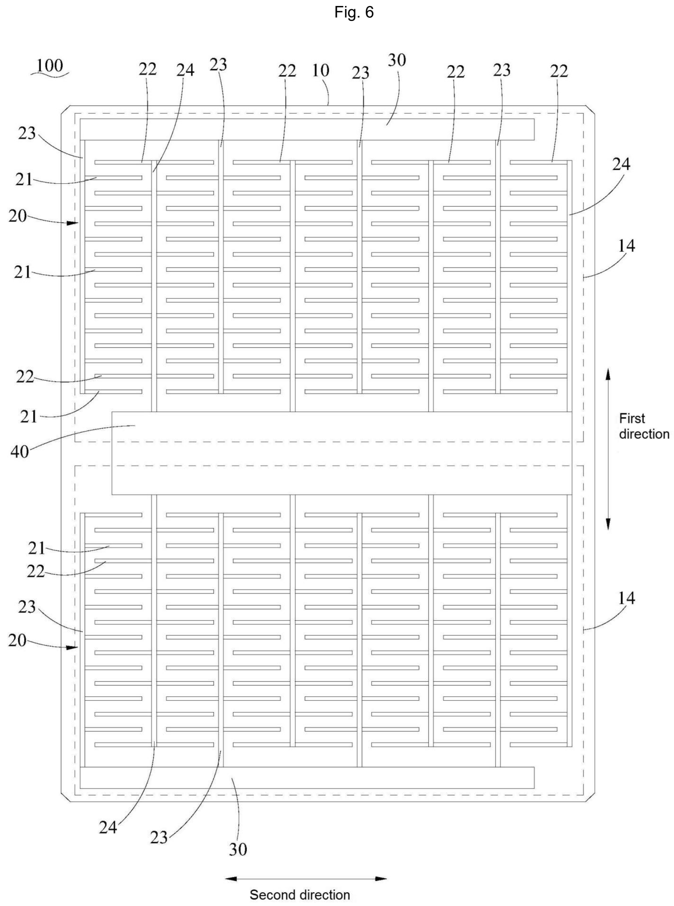

Further, with reference to Fig. 6, in such an example, when the back-contact solar cell 100 does not need to be segmented, two adjacent second conductive connectors 40 may be of an integrally formed structure, that is, the two adjacent back electrode structures 20 share one second conductive connector 40.

### Example 9

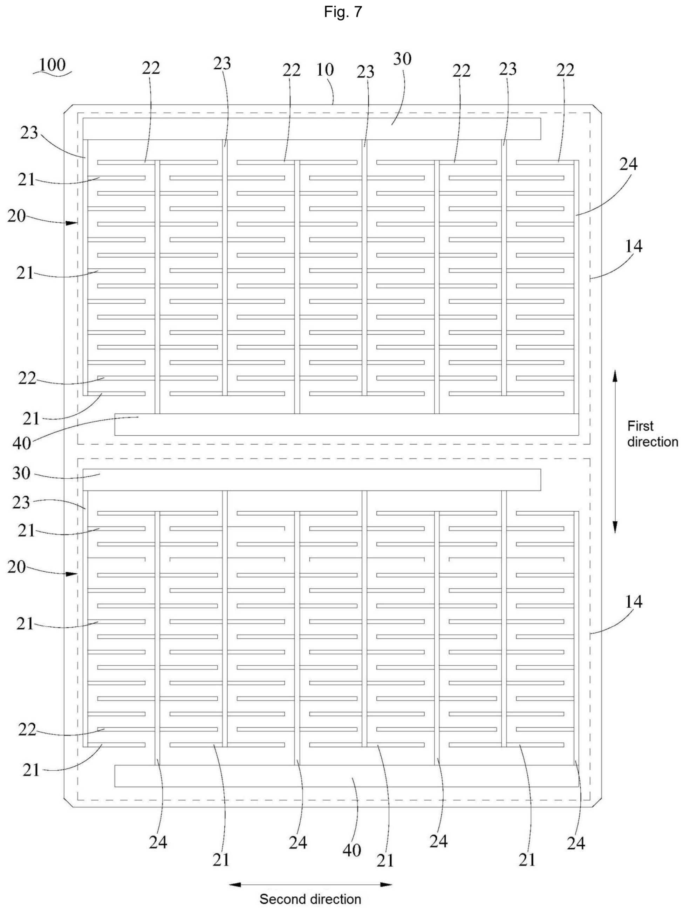

With reference to Fig. 7, in some examples, in the two adjacent back electrode structures 20, the first conductive connector 30 in one of the back electrode structures 20 is adjacent to the second conductive connector 40 in the other back electrode structure 20.

In this way, in the two adjacent back electrode structures 20, the first conductive connectors 30 and the second conductive connectors 40 are adjacent to each other. In this case, after segmentation is performed along an interval between the first conductive connector 30 and the second conductive connector 40 to form sliced cells, the sliced cell are connected in series to obtain a cell string.

It should be pointed out that when the back-contact solar cell 100 only has two electrode arrangement regions 14, an arrangement manner of the electrode arrangement regions may be arranged in an arrangement manner of Example 8 or Example 9.

When the back-contact solar cell 100 has more than two electrode arrangement regions 14, some two adjacent back electrode structures 20 may be arranged in the manner in Example 8, and other two adjacent back electrode structures 20 may be arranged in the manner in Example 9.

For example, when three electrode arrangement regions 14 are provided, as shown in Fig. 9, the second conductive connector 40 in the first back electrode structure 20 from top to bottom may be adjacent to the second conductive connector 40 in the second back electrode structure 20. The first conductive connector 30 in the third back electrode structure 20 may be adjacent to the first conductive connector 30 in the second back electrode structure 20.

Clearly, it can be understood that the arrangement manner may alternatively be that the second conductive connector 40 in the first back electrode structure 20 from top to bottom is adjacent to the first conductive connector 30 in the second back electrode structure 20, and the second conductive connector 40 in the third back electrode structure 20 is adjacent to the first conductive connector 30 in the second back electrode structure 20. In the present disclosure, an arrangement manner of the plurality of back electrode structures 20 is not limited. Clearly, in order to facilitate consistency of manufacture, the arrangement manner may preferably be the arrangement manner described in Example 8 or Example 9.

### Example 10

With reference to Fig. 5 to Fig. 7, in some examples, in the two adjacent back electrode structures 20, the first busbars 23 in one of the back electrode structures 20 are aligned with the first busbars 23 in the other back electrode structure 20 in the first direction. The second busbars 24 in one of the back electrode structures 20 are aligned with the second busbars 24 in the other back electrode structure 20 in the first direction.

In this way, since in the two adjacent back electrode structures 20, the first busbars 23 are aligned, and the second busbars 24 are also aligned, after the back-contact solar cell 100 is segmented into sliced cells, some of the sliced cells may be rotated by 180°, such that the busbars of the same polarity of the sliced cells can be aligned for subsequent welding processes, and then a cell string can be obtained.

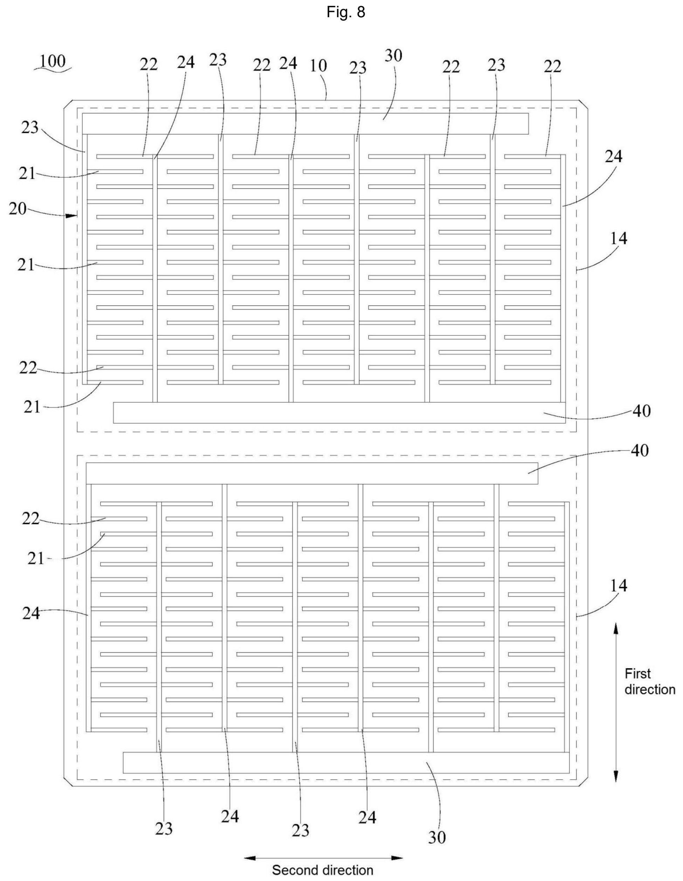

With reference to Fig. 8, in some examples, in the two adjacent back electrode structures 20, the first busbars 23 in one of the back electrode structures 20 are aligned with the second busbars 23 in the other back electrode structure 20 in the first direction. The second busbars 24 in one of the back electrode structures 20 are aligned with the first busbars 24 in the other back electrode structure 20 in the first direction.

In this way, since the first busbars 23 and the second busbars 24 of the two adjacent back electrode structures 20 are aligned, after the back-contact solar cell 100 is segmented into the sliced cells, the first busbars 23 and the second busbars 24 of the two adjacent sliced cells can be directly connected through solder tapes, so as to form a cell string without rotating the sliced cells. A process of rotating the sliced cells is eliminated, cost is saved, and production efficiency is improved.

It should be understood that in the example of the present disclosure, welding spots may be provided on the first busbars 23 and the second busbars 24 for soldering solder strips.

### Example 11

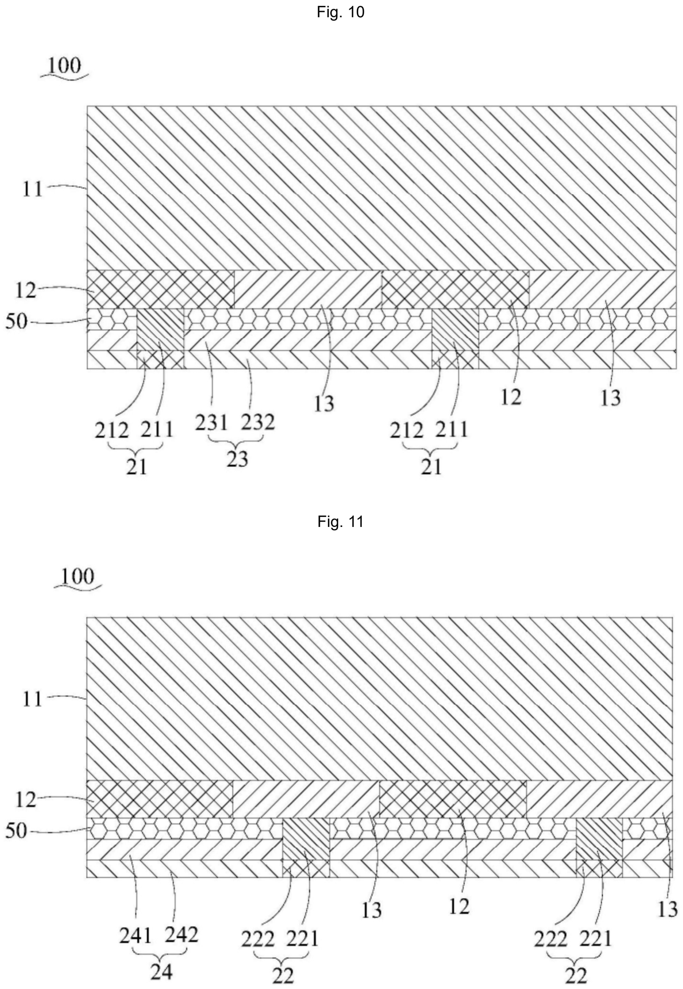

With reference to Fig. 10 and Fig. 11, in some examples, the first busbars 23 may include first busbar pre-plating layers 231 making contact with the first finger pre-plating layers 211 and first busbar electroplating layers 232 plating the first busbar pre-plating layers 231. The first busbar pre-plating layers 231 make contact with the first conductive connectors 30. The second busbars 24 include second busbar pre-plating layers 241 making contact with the second finger pre-plating layers 221 and second busbar electroplating layers 242 plating the second busbar pre-plating layers 241. The second busbar pre-plating layers 241 make contact with the second conductive connectors 40.

In this way, all the first busbar pre-plating layers 231 may be connected together by the first conductive connectors 30. All the second busbar pre-plating layers 241 may be connected together by the second conductive connectors 40. When the first busbar electroplating layers 232 and the second busbar electroplating layers 242 are formed, the first finger pre-plating layers 211, the second finger pre-plating layers 221, the first busbar pre-plating layers 231 and the second busbar pre-plating layers 241 may be plated with electroplating layers simultaneously by connecting the cathode of the plating apparatus to the first conductive connectors 30 and the second conductive connectors 40. Sequential plating is not needed. A plating process can be simplified, and the plating efficiency can be improved.

Specifically, in such an example, the first busbar electroplating layers 232 and the second busbar electroplating layers 242 may also be electroplated copper layers. Similar to the first finger pre-plating layers 211 and the second finger pre-plating layers 221, in some examples, each of the first busbar pre-plating layers 231 and the second busbar pre-plating layers 241 may include a seed layer. The seed layer may be prepared through a physical vapor deposition method. In this way, stable ohmic contact can be formed with the first polar doped layers 12 and the second polar doped layers 13 through the seed layers.

Specifically, the seed layers may be made of metallic material, which may preferably be alloy material. In some examples, a major component of the seed layers may include copper, aluminum or nickel.

It can be understood that in some examples, the seed layers may include a main component and a strengthening component. The main component may include any one or more of aluminum, silver, copper, magnesium, etc., and the strengthening component may include any one or more of molybdenum, titanium, tungsten, nickel, etc. Clearly, in some possible examples, the seed layers may be a single metal layer, as long as it can implement a subsequent plating function, which is not limited herein.

In such an example, the passivation film layer 50 may be deposited on the substrate 10 first. Then the passivation film layer 50 is opened in regions corresponding to the first busbar pre-plating layers 231 and the second busbar pre-plating layers 241. Then, the seed layers are deposited at openings through a physical vapor deposition method, such that the first busbar pre-plating layers 231 and the second busbar pre-plating layers 241 form ohmic contact with the first polar doped layers 12 and the second polar doped layers 13 respectively.

Furthermore, in some embodiments, the first busbar pre-plating layers 231 and the second busbar pre-plating layers 241 may also be prepared through a light-induced electroplating method or a chemical electroplating method, which is not limited herein. In this case, components of the first busbar pre-plating layers 231 and the second busbar pre-plating layers 241 may include copper or nickel.

In the description, the descriptions with reference to the terms "some examples," "illustrative examples," "instances," "specific instances," or "some instances," etc., mean that a specific feature, structure, material, or characteristic described in connection with the examples or instances falls within at least one example or instance of the present disclosure. In the description, the illustrative expressions of the above terms do not indicate the same examples or instances necessarily. Moreover, the specific feature, structure, material, or characteristic described can be combined in any one or more examples or instances in a suitable way.

Furthermore, what are described above are merely preferred examples of the present disclosure, and are not intended to limit the present disclosure. Any modifications, equivalent replacements, improvements, etc. made within the spirit and principles of the present disclosure should fall within the scope of protection of the present disclosure.

## Claims

1. A back-contact solar cell, comprising a substrate and at least one back electrode structure arranged on a light-sheltered surface of the substrate, wherein each back electrode structure comprises:
several first fingers and several second fingers that are spaced in a first direction and alternately arranged in sequence, wherein the first fingers comprise first finger pre-plating layers forming ohmic contact with the substrate and first finger electroplating layers plating the first finger pre-plating layers, and the second fingers comprise second finger pre-plating layers forming ohmic contact with the substrate and second finger electroplating layers plating the second finger pre-plating layers;
several first busbars and several second busbars that are spaced in a second direction and alternately arranged in sequence, wherein the first direction intersects with the second direction, the first busbars make contact with the first finger pre-plating layers, the first fingers are disconnected at the second busbars, the second busbars make contact with the second finger pre-plating layers, and the second fingers are disconnected at the first busbars; and
a first conductive connector and a second conductive connector, wherein the first conductive connector and the second conductive connector are arranged at two ends of the first busbars and the second busbars respectively, the first conductive connector is connected to ends of all the first busbars facing away from the second conductive connector, and the second conductive connector is connected to ends of all the second busbars facing away from the first conductive connector.

2. The back-contact solar cell according to claim 1, wherein a width of each first conductive connector is greater than a width of each first finger pre-plating layer, and a width of each second conductive connector is greater than a width of each second finger pre-plating layer.

3. The back-contact solar cell according to claim 1, wherein a width of each first finger pre-plating layer is 0.03 mm to 1 mm, and a width of each first conductive connector is 0.1 mm to 10 mm.

4. The back-contact solar cell according to claim 3, wherein the width of each first finger pre-plating layer is 0.03 mm to 0.6 mm, and the width of each first conductive connector is 0.1 mm to 5 mm.

5. The back-contact solar cell according to claim 1, wherein a width of each second finger pre-plating layer is 0.03 mm to 1 mm, and a width of each second conductive connector is 0.1 mm to 10 mm.

6. The back-contact solar cell according to claim 5, wherein the width of each second finger pre-plating layer is 0.03 mm to 0.6 mm, and the width of each second conductive connector is 0.1 mm to 5 mm.

7. The back-contact solar cell according to claim 1, wherein each first conductive connector and each second conductive connector are parallel to each first finger pre-plating layer and each second finger pre-plating layer.

8. The back-contact solar cell according to claim 1, wherein
each first conductive connector forms ohmic contact with the substrate; or
each second conductive connector forms ohmic contact with the substrate; or
each first conductive connector forms ohmic contact with the substrate, and each first conductive connector forms ohmic contact with the substrate.

9. The back-contact solar cell according to any one of claims 1-8, wherein a light-sheltered surface of the substrate has several electrode arrangement regions in the first direction, and the back electrode structure is arranged in each electrode arrangement region.

10. The back-contact solar cell according to claim 9, wherein in two adjacent back electrode structures, the second conductive connectors in the two adjacent back electrode structures are adjacent to each other.

11. The back-contact solar cell according to claim 10, wherein in the two adjacent back electrode structures, the two adjacent second conductive connectors are of an integrally formed structure.

12. The back-contact solar cell according to claim 9, wherein in the two adjacent back electrode structures, the first conductive connector in one of the back electrode structures is adjacent to the second conductive connector in the other back electrode structure.

13. The back-contact solar cell according to claim 9, wherein in the two adjacent back electrode structures, the first busbars in the one of the back electrode structures are aligned with the first busbars in the other back electrode structure in the first direction, and the second busbars in the one of the back electrode structures are aligned with the second busbars in the other back electrode structure in the first direction; or the first busbars in the one of the back electrode structures are aligned with the second busbars in the other back electrode structure in the first direction, and the second busbars in the one of the back electrode structures are aligned with the first busbars in the other back electrode structure in the first direction.

14. The back-contact solar cell according to claim 1, wherein each of the first finger pre-plating layers and the second finger pre-plating layers comprises a seed layer, and the seed layer is prepared through a physical vapor deposition method.

15. The back-contact solar cell according to claim 14, wherein a component of the seed layer comprises copper, aluminum or nickel.

16. The back-contact solar cell according to claim 1, wherein the first finger pre-plating layers and the second finger pre-plating layers are prepared through a light-induced electroplating method or a chemical electroplating method.

17. The back-contact solar cell according to claim 16, wherein components of the first finger pre-plating layers and the second finger pre-plating layers comprise copper or nickel.

18. The back-contact solar cell according to claim 1, wherein the first busbars comprise first busbar pre-plating layers making contact with the first finger pre-plating layers and first busbar electroplating layers plating the first busbar pre-plating layers, the first busbar pre-plating layers make contact with the first conductive connectors, the second busbars comprise second busbar pre-plating layers making contact with the second finger pre-plating layers and second busbar electroplating layers plating the second busbar pre-plating layers, and the second busbar pre-plating layers make contact with the second conductive connector.

19. A battery assembly, comprising the plurality of back-contact solar cells according to any one of claims 1-18, or a plurality of sliced cells obtained by cutting and/or fragmenting the back-contact solar cell according to any one of claims 1-18.

20. A photovoltaic system, comprising the cell assembly according to claim 19.
